# FASCICULE DE BREVET EUROPEEN

(11) **EP 0 368 742 B1**
(45) Date de publication et mention de la délivrance du brevet: **04.02.1998**
(21) Numéro de dépôt: 89403053.5
(22) Date de dépôt: 07.11.1989
(51) Int. Cl.: H03K 5/02, H03K 19/0175

(54) **Amplificateur binaire intégré et circuit intégré l'incorporant**
Digitalverstärker und diesen enthaltende integrierte Schaltung
Digital amplifier and integrated circuit including such

(30) Priorité: 08.11.1988 FR 8814540
(43) Date de publication de la demande: 16.05.1990
(73) Titulaire: BULL S.A., 92800 Puteaux (FR)
(72) Inventeur: Neu, Georges, F-75016 Paris (FR)
(74) Mandataire: Denis, Hervé

(56) Documents cités:
- EP-A- 0 220 856
- EP-A- 0 241 785
- US-A- 4 476 403
- US-A- 4 638 186

## Description

L'invention se rapporte aux amplificateurs binaires et aux circuits intégrés les incorporant. Plus précisément, elle concerne les amplificateurs binaires intégrés dans un matériau semiconducteur et essentiellement composés d'au moins un transistor à effet de champ associé à des transistors bipolaires. Elle est plus particulièrement adaptée aux circuits intégrés incluant des transistors à effet de champ de types complémentaires et des transistors bipolaires, tels s que les circuits intégrés BiCMOS dans lesquels les transistors à effet de champ sont du type CMOS (Complementary Metal Oxide Semiconductor). L'invention s'applique notamment aux amplificateurs binaires de transmission dans des systèmes de traitement de l'information, tels que les amplificateurs d'interface (amplificateurs tampons) connectés aux bornes de sortie d'un circuit intégré pour transmettre un signal binaire à un circuit de charge. Par exemple, le circuit de charge peut être un bus, ou une liaison avec une mémoire intégrée. Dans les applications où plusieurs amplificateurs binaires sont reliés à un bus, on adjoint à chacun d'eux un troisième état logique, dit à haute impédance, commandé par un signal de validation. Dans cet état, l'amplificateur binaire assure une isolation électrique avec le bus de façon à ne pas interférer avec les signaux émis sur le bus à partir d'un autre amplificateur. L'invention concerne aussi ces amplificateurs.

Les amplificateurs binaires intégrés, composés d'un transistor à effet de champ comme élément d'entrée et d'un transistor bipolaire comme élément de sortie ont l'inconvénient d'avoir un fonctionnement se dégradant lorsque la capacité de son circuit de charge dépasse une valeur relativement faible, 10 pF par exemple. Une solution consiste à as'socier au transistor à effet de champ deux transistors bipolaires en cascade (montage Darlington). Pour optimiser le temps de propagation du signal dans l'amplificateur, on élimine les charges électriques qui se sont accumulées sur les bases des transistors bipolaires. L'élimination se fait pendant la période de blocage des transistors bipolaires, au moyen d'éléments de décharge reliant les bases respectives des transistors à un potentiel d'alimentation, la masse ordinairement. Chaque élément de décharge est la résistance servant de polarisation des transistors bipolaires pendant leur fonctionnement, ou un transistor à effet de champ dans un amplificateur n'utilisant pas de résistance. Un tel amplificateur a l'avantage de tolérer de fortes capacités de son circuit de charge, jusqu'à 200 pF par exemple, et de ne nécessiter l'emploi que de transistors de dimensions normales.

Plus généralement, on obtient les mêmes avantages en appliquant la même solution aux amplificateurs binaires classiques composés d'au moins deux transistors à effet de champ associés respectivement à un transistor bipolaire. Le plus simple de ces amplificateurs inclut deux transistors à effet de champ de types complémentaires recevant le même signal d'entrée. Le transistor à effet de champ pour l'amplification du niveau haut est associé à deux transistors bipolaires en cascade. Le transistor à effet de champ pour l'amplification du niveau bas est associé à un seul transistor bipolaire. Dans l'amplificateur, la base de chaque transistor bipolaire est pourvue d'un élément de décharge de capacité, pouvant être une résistance ou un transistor à effet de champ. Un tel amplificateur est décrit dans le brevet US 4 638 186.

La mise en cascade de transistors bipolaires a cependant l'inconvénient de réduire l'excursion du signal de sortie. Cet inconvénient apparaît nettement en utilisant par exemple un amplificateur composé d'un couple de transistors CMOS associés chacun à deux transistors bipolaires en cascade. On sait que la tension de jonction base-émetteur (Vbe) d'un transistor bipolaire peut atteindre 0,8 volt. Par conséquent, si par exemple les potentiels d'alimentation sont la masse et + 5 volts, le signal de sortie oscille entre environ 1,6 volts et 3,4 volts. En d'autres termes, l'amplitude du signal de sortie est seulement de 2,6 volts environ, soit approximativement la moitié de la tension d'alimentation (5 volts). La première conséquence d'une amplitude aussi affaiblie est que le signal de sortie est très sensible au bruit. Un signal parasite peut altérer le fonctionnement du composant commandé par l'amplificateur. Comme seconde conséquence, le signal de sortie ne peut plus être compatible avec un circuit de charge incluant un circuit intégré - une mémoire intégrée par exemple - fait en technologie TTL (Transistor-Transistor Logic). Cette technologie requiert des potentiels qui ne peuvent pas être atteints par un signal de sortie trop affaibli de l'amplificateur binaire. La troisième conséquence réside dans la nécessité d'avoir une tension d'alimentation élevée. Cette exigeance s'oppose à la tendance actuelle d'utiliser de plus faibles tensions d'alimentation, 3 volts par exemple. Il est clair aussi, comme quatrième conséquence, qu'il est impossible d'associer trois transistors binaires en cascade pour accommoder un amplificateur avec un circuit de charge très fortement capacitif, de plus de 200 pF par exemple. Une autre conséquence très importante est liée au fait que le niveau bas du signal de sortie diffère du potentiel de référence, la masse ordinairement, de la tension de jonction Vbe de chaque transistor bipolaire utilisé pour l'amplification du niveau bas. La tension Vbe est génératrice, dans de nombreuses applications, d'un courant parasite dans le circuit de charge de l'amplificateur. Par exemple, si le circuit de charge est une mémoire intégrée, composée de nombreuses cellules, un courant de fuite traverse les transistors de transfert de chaque cellule, de sorte que l'ensemble des courants de fuite dans les cellules produisent des différences de potentiel relativement élevées pouvant perturber le fonctionnement désiré de la mémoire. Pour limiter le niveau bas du signal de sortie à un seul Vbe de la masse, l'amplification du niveau bas est habituellement faite par un seul transistor bipolaire alors que l'amplification du niveau haut est faite par un montage Darlington, comme illustré dans le brevet US 4 638 186 précité. Cela limite donc sensiblement les performances désirées de l'amplificateur.

Dans le brevet US 4 476 403, le circuit de sortie de l'amplificateur comprend aussi un transistor bipolaire pour l'amplification du niveau bas, et deux transistors en cascade constituant un montage Darlington pour l'amplification du niveau haut. Le transistor bipolaire du niveau bas est du type Schottky afin de présenter une tension Vbe de 0,3 volt environ. Dans le montage Darlington servant à l'amplification du niveau haut, la tension Vbe du premier transistor est sensiblement shuntée par une liaison appliquant la base du transistor bipolaire de sortie au potentiel haut d'alimentation. Cependant, le principe de fonctionnement de la liaison shunt qui est décrite et illustrée dans ce brevet ne répond pas au problème posé par l'amplification du niveau bas et présenté plus haut.

L'invention donne une solution simple et efficace pour répondre au problème posé par l'amplification du niveau bas tout en conservant les avantages des transistors en cascade dans un amplificateur BiMOS ou BiCMOS en vue d'obtenir un signal de sortie de grande excursion, sensiblement égale à la tension d'alimentation. L'invention assure ainsi une immunité au bruit et une compatibilité avec la technologie TTL, et permet l'application d'une faible tension d'alimentation et l'extension du nombre des transistors bipolaires en cascade pour l'amplification des niveaux haut et bas.

Une première version se référant aux figures 1 à 3 et une seconde version se référant aux figures 4 et 5 d'un amplificateur binaire intégré conforme à l'invention sont respectivement définies par les revendications 1 et 3.

Il s'ensuit qu'un circuit intégré conforme à l'invention est caractérisé en ce qu'il comprend au moins un amplificateur tel que défini précédemment.

Les caractéristiques et avantages de l'invention ressortiront clairement de la description qui suit, donnée à titre d'exemple et faite en référence aux dessins annexés.

Dans les dessins :

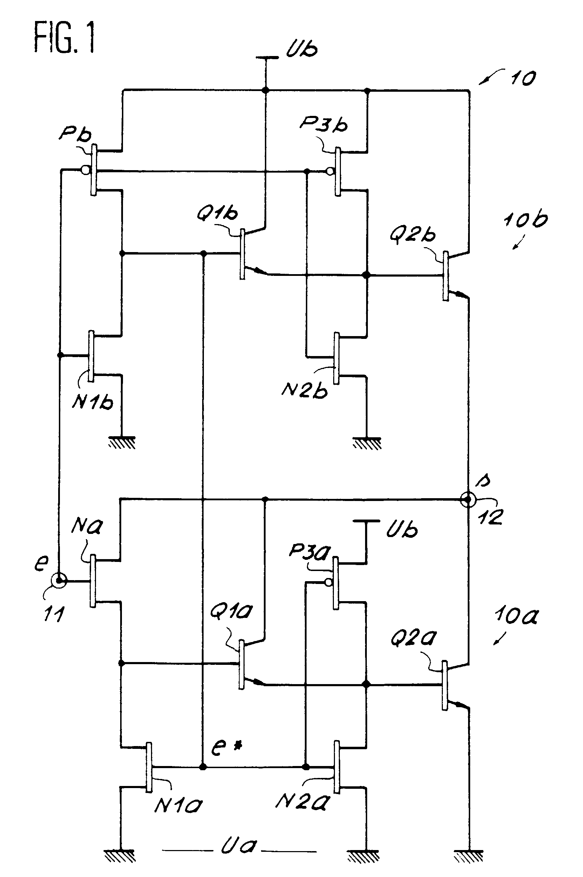

- la figure 1 est un schéma du circuit électrique d'un premier type d'amplificateur binaire intégré conforme à l'invention, à deux états logiques ;

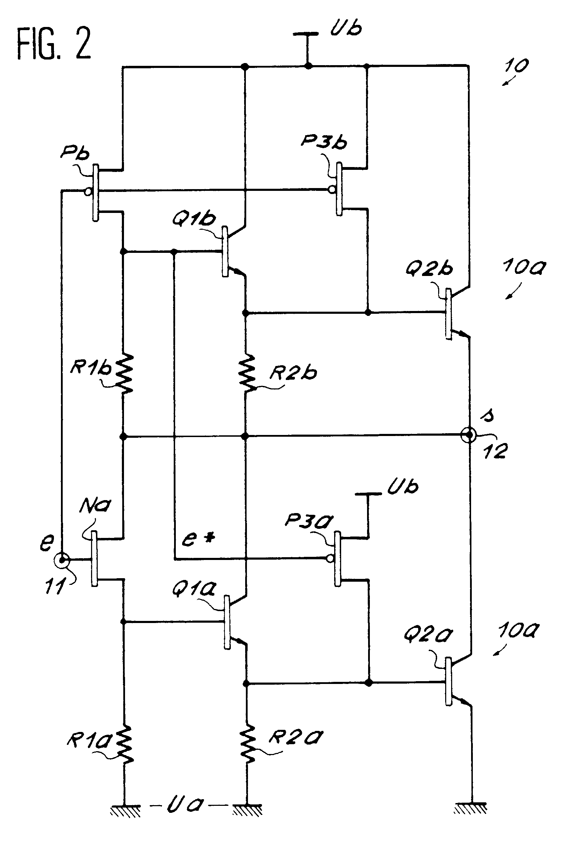

- la figure 2 est un schéma du circuit électrique d'une variante de réalisation conforme à l'invention de l'amplificateur représenté sur la figure 1 ;

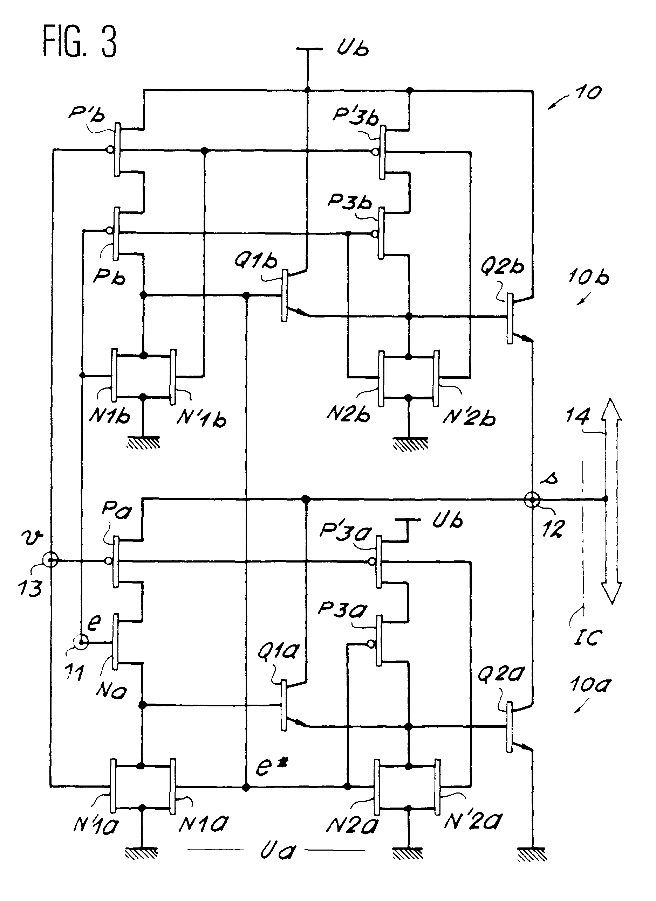

- la figure 3 est un schéma du circuit électrique d'un second type d'amplificateur conforme à l'invention, présentant trois états logiques et fait sur la base du type d'amplificateur représenté sur la figure 1 ;

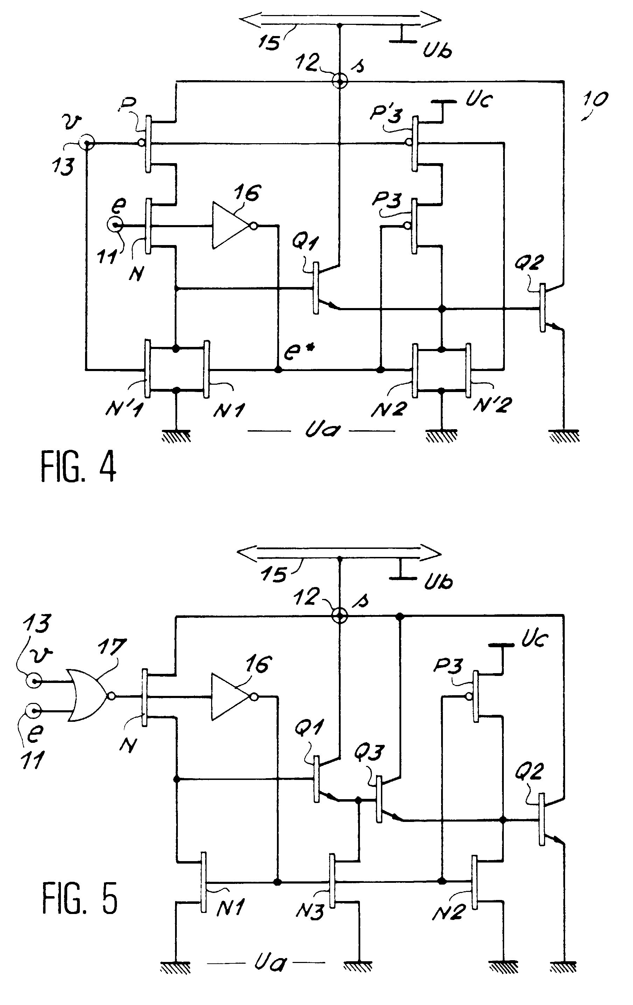

- les figures 4 et 5 sont des schémas de circuits électriques de variantes de réalisation conformes à l'invention.

Les exemples illustrés d'amplificateurs 10 conformes à l'invention se rapportent à la technologie biCMOS. Les amplificateurs 10 sont alimentés en énergie électrique sous deux potentiels Ua (la masse) et Ub (+ 5 volts), par exemple. Ils reçoivent le signal d'entrée e et délivrent le signal de sortie s. Les transistors n-MOS sont désignés par N, les transistors p-MOS par P, et les transistors bipolaires par Q.

Les figures 1 et 2 représentent respectivement les deux familles d'un même type d'amplificateur 10 conforme à l'invention. Dans ces figures, les amplificateurs 10 reçoivent le signal d'entrée e sur une borne d'entrée 11 et délivrent un signal de sortie s sur une borne de sortie 12. Les amplificateurs 10 des figures 1 et 2 ont deux états stables et constituent des inverseurs formés sur la base d'un couple de transistors CMOS, Na et Pb. On définit dans les amplificateurs 10 deux sections 10a, 10b respectivement liées aux transistors CMOS, Na et Pb.

Dans l'amplificateur 10 de la figure 1, les transistors Na et Pb sont respectivement en série avec les premiers transistors N1a et N1b ayant leur source à la masse. En d'autres termes, les transistors Na et N1a ont leurs trajets drain-source en série, comme les transistors Pb et N1b. Le drain du transistor Na est connecté à la borne de sortie 12 et le drain du transistor Pb est connecté au potentiel d'alimentaion Ub. Les grilles des transistors Na, Pb et N1b sont connectées à la borne d'entrée 11 pour recevoir le signal d'entrée e. La grille du transistor N1a est connectée à la source du transistor Pb représentative du signal d'entrée complémentaire e*. Le potentiel Ub est appliqué aux collecteurs d'un groupe de deux transistors bipolaires Q1b et Q2b montés en cascade. Le transistor Q1b a sa base connectée à la source du transistor Pb et son émetteur connecté à la base du transistor Q2b. La borne de sortie 12 est connectée à l'émetteur du transistor Q2b ainsi qu'aux collecteurs d'un autre groupe de deux transistors bipolaires Q1a et Q2a montés en cascade. Le transistor Q1a a sa base connectée à la source du transistor Na et son émetteur connecté à la base du transistor Q2a ayant son émetteur à la masse. En d'autres termes, les transistors Q1a, Q2a forment un montage Darlington, comme les transistors Q1b et Q2b. Les bases des transistors Q2a et Q2b sont respectivement connectées aux drains de deux seconds transistors N2a, N2b ayant leurs sources à la masse. La grille du transistor N2b reçoit le signal d'entrée e et la grille du transistor N2a reçoit le signal d'entrée complémentaire e*.

En fonctionnement, quand le signal d'entrée e a le niveau logique "0", le transistor Na est bloqué et le transistor Pb conduit. Les transistors Q1a et Q2a sont bloqués, tandis que les transistors Q1b et Q2b conduisent. Les transistors N1a et N2a conduisent et déchargent les bases des transistors Q1a et Q2a, tandis que les transistors N1b et N2b sont bloqués. Le signal de sortie s sur la borne 12 a donc le niveau logique "1". Quand le signal d'entrée e prend le niveau logique "1", les transistors Pb, Q1b, Q2b ne sont plus conducteurs. Par contre, les transistors N1b et N2b conduisent et écoulent ainsi vers la masse les charges qui s'étaient accumulées sur les bases des transistors bipolaires respectifs Q1b et Q2b pendant leur fonctionnement. Dans la section 10a, les transistors Na, Q1a, Q2a deviennent conducteurs et les transistors N1a et N2a deviennent non conducteurs. Le signal de sortie s prend donc le niveau logique "0".

Un premier avantage de l'amplificateur 10 tel qu'illustré est de pouvoir fonctionner correctement en dépit d'une capacité très élevée (jusqu'à 200 pF par exemple) du circuit de charge connecté à la borne de sortie 12. Le second avantage réside dans les dimensions des transistors de l'amplificateur 10, qui n'ont pas à être augmentées pour offrir le premier avantage. Cependant, les niveaux bas et haut du signal de sortie, correspondant aux états logiques "0" et "1", s'écartent respectivement des potentiels Ua et Ub de la valeur 2Vbe, où Vbe désigne la tension de jonction base-émetteur d'un transistor bipolaire qui peut atteindre 0,8 volt.

L'invention consiste à relier dans chaque section 10a, 10b la base de chaque transistor bipolaire de sortie Q2a, Q2b au potentiel d'alimentation Ub par l'intermédiaire du trajet drain-source d'un troisième transistor à effet de champ dont le type et la commande assurent sa conduction lorsque les transistors bipolaires du groupe associé au transistor de sortie sont conducteurs. Dans l'exemple illustré, on ajoute deux troisièmes transistors P3a, P3b ayant leurs grilles recevant respectivement le signal d'entrée complémentaire e* et le signal d'entrée e. Par conséquent, la conduction du transistor P3a quand les transistors Q1a et Q2a conduisent (e = "1") contribue à injecter un courant de base suffisant dans le transistor Q2a pour maintenir le niveau bas du signal de sortie s très près de 0 volt. D'autre part, quand les transistors Q1b et Q2b conduisent (e = "0"), la conduction du transistor P3b fait remonter rapidement le potentiel de la base du transistor Q2b pour atteindre le potentiel Ub, de sorte que la borne 12 est au potentiel Ub - Vbe (du transistor Q2b). En conclusion, le signal de sortie s de l'amplificateur 10 conforme à l'invention a un niveau bas sensiblement égal à Ua (0 volt) et un niveau haut qui différe du potentiel Ub d'un seul Vbe, soit au maximum de 0,8 volt. Le signal de sortie s conserve donc une bonne immunité au bruit et peut s'adapter à la technologie TTL. En outre, l'amplificateur 10 conserve ses avantages si l'on ajoute un ou plusieurs transistors en cascade dans chaque section 10a, 10b. L'amplificateur 10 peut donc s'adapter à de très hautes capacités de charge, supérieures à 200 pF par exemple, en associant chaque transistor Na, Pb à au moins trois transistors bipolaires en cascade. L'adjonction des transistors P3a et P3b aux transistors bipolaires de sortie respectifs Q2a, Q2b fournira encore un signal de sortie s similaire à celui fourni par l'amplificateur 10 représenté sur la figure 1.

L'amplificateur 10 de la figure 2 est une variante de réalisation de l'amplificateur 10 représenté sur la figure 1. Les mêmes éléments portent les mêmes chiffres de référence. Selon cette variante, les transistors N1a, N2a, N1b, N2b de la figure 1 sont remplacés par des résistances R1a, R2a, R1b, R2b. Les résistances R1a et R1b sont en série avec les transistors Na et Pb. Les résistances R1a et R2a relient respectivement les bases des transistors Q1a, Q2a au potentiel Ua. Les résistances R1b, R2b relient respectivement les bases des transistors Q1b, Q2b au drain du transistor Na et à la borne 12. Les résistances servent à la fois d'éléments de polarisation des transistors bipolaires lorsqu'ils conduisent, et d'éléments de décharge de la capacité de leurs bases lorsqu'ils sont bloqués. L'invention s'applique de la même manière que celle décrite à la figure 1. La base de chaque transistor bipolaire de sortie Q2a, Q2b est reliée au potentiel Ub par l'intermédiaire d'un transistor à effet de champ P3a, P3b. Le transistor P3a a sa grille connectée à la source du transistor Pb pour recevoir le signal d'entrée complémentaire e∗. Le transistor P3b a sa grille connectée à la borne d'entrée 11 pour recevoir le signal d'entrée e. La conduction du transistor P3a maintient le niveau bas du signal de sortie s a une valeur très proche de la masse. La conduction du transistor P3b porte le niveau haut du signal de sortie s à Ub - Vbe. De même, on pourrait inclure dans chaque section 10a, 10b un troisième transistor bipolaire en cascade et obtenir les mêmes avantages.

L'amplificateur 10 représenté sur la figure 3 constitue un second type d'amplificateurs conformes à l'invention, destinés à délivrer leur signal de sortie à un bus et appelés émetteurs de bus. L'amplificateur 10 du second type présente trois états logiques et a une structure fondée sur le premier type d'amplificateur tel que représenté sur la figure 1. Dans les figures 1 et 3, les mêmes éléments portent les mêmes chiffres de référence. Dans la figure 3, l'amplificateur 10 porte une seconde borne d'entrée 13 pour un signal de validation v, qui s'ajoute au signal d'entrée e appliqué sur la borne d'entrée 11. Le second type d'amplificateur 10 est surtout un amplificateur tampon, dont la borne de sortie 12 correspond dans l'exemple illustré à la borne de sortie d'un circuit intégré IC délimité partiellement et schématiquement par un trait fantôme dans la figure 3. Plus généralement, la borne de sortie 12 peut être reliée à une borne de sortie séparée du circuit intégré. La borne de sortie 12 est destinée à une liaison avec un bus 14 extérieur au circuit intégré IC, comme illustré. Les deux sections 10a, 10b de l'amplificateur 10 sont aussi formées par les deux transistors CMOS Na et Pb recevant sur leurs grilles le signal d'entrée e. Ils sont associés de la même façon aux transistors N1a et N1b, ainsi qu'aux transistors bipolaires Q1a, Q2a ; Q1b, Q2b. Les transistors N1a, N2a, N1b, N2b sont connectés de la même manière qu'à la figure 1 et sont respectivement mis en parallèle avec des transistors additionnels N'1a, N'2a, N'1b, N'2b recevant le signal de validation v sur leurs grilles. Le transistor Na a son drain relié à la borne de sortie 12 par l'intermédiaire d'un transitor Pa recevant le signal de validation v sur sa grille. Le transistor Pb a son drain relié au potentiel Ub par l'intermédiaire d'un transistor P'b recevant le signal de validation v sur sa grille. Selon l'invention, les bases des transistors bipolaires de sortie Q2a, Q2b sont respectivement reliées au potentiel Ub par l'intermédiaire des transistors P3a, P3b, dont les grilles sont connectées de la même manière qu'à la figure 1 et dont les trajets drain-source sont en série avec ceux de deux transistors additionnels respectifs P'3a, P'3b recevant le signal de validation v sur leur grille.

Quand le signal de validation v a l'état logique "1", les transistors Pa et P'b sont non conducteurs. L'amplificateur 10 est ainsi placé en état de non fonctionnement et présente une haute impédance à tout signal extérieur appliqué sur la borne de sortie 12. Dans cet état, l'amplificateur 10 ne perturbe pas la transmission de tout signal sur le bus 14 émanant d'un autre amplificateur 10 associé au bus. Quand le signal de validation v a l'état logique "0", il autorise le fonctionnement normal de tous les transistors de l'amplificateur 10 qui sont communs avec ceux de la figure 1, de façon à donner un signal de sortie s complémentaire du signal d'entrée e. En particulier, on notera que les transistors P'3a, P'3b sont alors en condition passante pour autoriser le fonctionnement normal des transistors P3a et P3b conformes à l'invention.

Les figures 4 et 5 illustrent des amplificateurs 10 d'un troisième type auxquels peut s'appliquer aussi l'invention. Ces amplificateurs sont adaptés à une connexion sur un bus préchargé 15 et communément appelés des émetteurs de bus préchargé. La présence du bus 15 implique qu'ils possèdent trois états, comme l'amplificateur 10 représenté sur la figure 3. Comme ce dernier, les amplificateurs 10 des figures 4 et 5 reçoivent un signal d'entrée e et un signal de validation v, et leur borne de sortie 12 est connectée au bus 15. Contrairement au bus 14 de la figure 3, le bus 15 dans les figures 4 et 5 est préchargé, ordinairement au niveau haut correspondant au potentiel Ub. De la sorte, les amplificateurs 10 des figures 4 et 5 ne reçoivent de manière classique que le potentiel Ua (la masse).

Le circuit de l'amplificateur 10 représenté sur la figure 4 correspond à la section 10a de l'amplificateur 10 représenté sur la figure 3. Dans ces deux figures, les mêmes éléments portent les mêmes chiffres de référence, à l'exception de la lettre a. La borne de sortie 12 est reliée à la masse par l'intermédiaire des transistors P, N et N1 montés en série. Le signal d'entrée e sur la borne d'entrée 11 est appliqué sur la grille du transistor N ainsi que sur l'entrée d'un inverseur 16, qui fournit le signal d'entrée complémentaire e* au transistor N1. Le signal de validation v sur la borne de validation 13 est appliqué sur la grille du transistor P. La jonction de la source du transistor N avec le drain du transistor N1 est connectée au transistor bipolaire Q1, dont le collecteur est connecté à la borne de sortie 12 et dont l'émetteur est connecté à la base du transistor bipolaire de sortie Q2. Le transistor Q2 a son émetteur à la masse et son collecteur connecté à la borne de sortie 12. Sa base est reliée à la masse par le transistor N2 et à un potentiel fixe Uc (+ 3 volts, par exemple) par l'intermédiaire des deux transistors P3 et P'3 montés en série. Les transistors N1 et N2 sont montés en parallèle avec des transistors respectifs N'1 et N'2. Les grilles des transistors N1, N2 et P3 reçoivent le signal d'entrée complémentaire e*. Les grilles des transistors P, N'1, N'2 et P'3 reçoivent le signal de validation v.

Lorsque le signal de validation v a l'état logique "1", les transistors P et P'3 sont bloqués, tandis que les transistors N'1 et N'2 sont conducteurs, déchargeant ainsi les capacités des bases des transistors Q1 et Q2. L'amplificateur 10 présente ainsi à sa borne de sortie 12 une haute impédance pour la transmission de tout signal sur le bus 15 émis par un autre amplificateur associé au bus. Si l'amplificateur 10 représenté sur la figure 4 doit émettre, le signal de validation v prend l'état logique "0". Dans ces conditions, les transistors P et P'3 sont conducteurs et les transistors N'1 et N'2 sont bloqués, de sorte que les transistors N, Q1, Q2, N1, N2 et P3 peuvent fonctionner normalement pour que le bus prenne l'état logique du signal d'entrée e. Si le signal d'entrée e a l'état logique "1", les transistors N, P3, Q1, Q2 sont conducteurs et les transistors N1 et N2 sont bloqués. Les transistors N et P autorisent ainsi l'injection d'un courant dans la base du transistor Q1. Les transistors Q1 et Q2 amplifient ce courant et permettent la décharge rapide de la capacité formée par le bus 15. Sans les transistors P3 et P'3 ajoutés conformément à l'invention, les niveaux bas du bus 15 correspondant au signal d'entrée e à l'état logique "1" auraient la valeur des 2Vbe des transistors Q1 et Q2, soit une valeur inférieure ou égale à 1,6 volts. Grâce aux transistors P3 et P'3, le niveau bas du bus 15 peut atteindre la valeur du potentiel Ua, la masse en l'occurrence. Comme dans les amplificateurs précédents, les transistors P3 et P'3 conduisent pour injecter un courant dans la base du transistor bipolaire Q2 pendant la décharge du bus 15. Le courant injecté est de l'ordre de quelques dizaines de micro-ampères, de sorte que la dissipation résultante est très faible. Grâce à l'invention, le signal émis sur le bus offre une grande immunité au bruit et peut s'adapter à la technologie TTL. De plus, il présente ces mêmes avantages quel que soit le nombre des transistors bipolaires du groupe associé au transistor N recevant le signal d'entrée e.

La figure 5 présente un amplificateur 10 conforme à l'invention, constituant une variante de réalisation de l'amplificateur 10 représenté sur la figure 4. Dans les figures 4 et 5, les mêmes composants sont désignés par les mêmes chiffres de référence. Cette variante donne à l'amplificateur 10 de la figure 5 une structure partiellement identique à celle de la section 10a de l'amplificateur 10 représenté sur la figure 1. La borne de sortie 12 connectée au bus préchargé 15 est reliée au potentiel d'alimentation Ua (la masse) par les transistors N et N1 et, d'autre part, par un groupe formé des deux transistors bipolaires Q1 et Q2 et d'un transistor bipolaire additionnel Q3, tous montés en cascade selon une configuration en Darlington. La jonction de la source du transistor N avec le drain du transistor N1 est connectée à la base du transistor Q1. L'émetteur du transistor Q1 est connecté à la base du transistor additionnel Q3. Le transistor de sortie Q2 a son émetteur à la masse, sa base connectée à l'émetteur du transistor Q3 et son collecteur réuni aux collecteurs des transistors Q1 et Q3 ainsi qu'à la borne de sortie 12. La base du transistor de sortie Q2 est reliée à la masse par le transistor N2 et à un potentiel fixe Uc (+ 3 volts par exemple) par un transistor P3. La base du transistor Q3 est aussi déchargée vers la masse sous l'action d'un transistor à effet de champ N3. Le signal d'entrée e sur la borne d'entrée 11 et le signal de validation v sur la borne de validation 13 sont appliqués à une porte NOR 17, dont la sortie est appliquée directement à la grille du transistor N et, par l'intermédiaire de l'inverseur 16, sur les grilles des transistors N1, N2, N3 et P3. L'inverseur 16 et la porte NOR 17 sont avantageusement faits en technologie CMOS.

Si le signal de validation v a l'état logique "1", l'amplificateur 10 de la figure 5 n'est pas sélectionné pour émettre sur le bus 15. Le transistor N est bloqué et le transistor N1 conduit de sorte que la base du transistor Q1 est à la masse. Les transistors Q1, Q2 et Q3 sont donc bloqués et leurs bases déchargées par les transistors respectifs N1, N2 et N3. La capacité équivalente formée par le bus 15 reste préchargée au niveau haut correspondant au potentiel Ub. Si l'amplificateur 10 doit émettre sur le bus 15, le signal de validation v prend l'état logique "0". Si le signal d'entrée est l'état logique "1", l'amplificateur reste dans l'état précédent. Par contre, si le signal d'entrée e a l'état logique "0", les transistors N et P3 conduisent alors que les transistors N1 et N2 sont bloqués. Les transistors Q1, Q3 et Q2 conduisent pour décharger la capacité formée par le bus 15. Grâce au transistor P3, le bus se décharge pour atteindre la valeur du potentiel Ua, soit 0 volt.

Bien que les potentiels Ub et Uc dans les exemples décrits sont différents, il est évident que le fonctionnement serait identique pour deux valeurs égales de Ub et Uc. De même, la variante de la figure 5 qui illustre un groupe de trois transistors bipolaires en cascade peut s'appliquer aux autres amplificateurs 10 illustrés. De plus, comme la variante de la figure 5 s'inspire de la section 10a de l'amplificateur 10 représenté sur la figure 1, elle peut aussi subir la variante de la section 10a de l'amplificateur 10 représenté sur la figure 2. En d'autres termes, les transistors N1, N2 et N3 dans la figure 5 pourraient être remplacés par des résistances R1, R2 et R3. Il est aussi évident qu'un panachage de résistances et de transistors comme éléments de décharge de base pourrait être fait dans un même groupe de transistors en cascade. Enfin, il est clair que dans les figures 4 et 5, le bus 15 pourrait être préchargé au niveau Ub = 0 volt, avec Ua de + 5 volts par exemple.

D'une manière générale, la description qui précède met en relief l'application de l'invention pour tout amplificateur binaire incorporant au moins un transistor à effet de champ réagissant à un signal d'entrée et associé à au moins deux transistors bipolaires en cascade. L'invention consiste alors à relier la base du transistor bipolaire de sortie à un potentiel fixe par l'intermédiaire d'un transistor à effet de champ dont le type et la commande assurent sa conduction lorsque les transistors bipolaires sont conducteurs. Il est clair que la présence d'un élément de décharge de la base de chaque transistor bipolaire n'est pas nécessaire pour obtenir les avantages de l'invention. Les éléments de décharge ne servent qu'à accroître le temps de transit du signal d'entrée e dans l'amplificateur 10 vers la borne de sortie 12. Dans ce sens, ils seront en pratique toujours avantageusement associés aux transistors bipolaires. La description précédente a mis aussi en évidence le fait que la commande d'un transistor par le signal d'entrée e ou le signal de validation v comprend leurs compléments e* et v*.

## Revendications

1. Amplificateur binaire intégré (10) comprenant une borne d'entrée (11) recevant un signal d'entrée (e) binaire, une borne de sortie (12) fournissant un signal de sortie (s) binaire, un potentiel bas (Ua) et un potentiel haut (Ub) d'alimentation une section basse (10a) comprenant un transistor bipolaire de sortie (Q2a) dont le trajet collecteur-émetteur est connecté entre le potentiel bas (Ua) d'alimentation et la borne de sortie de l'amplificateur, et une section haute (10b) incluant des transistors bipolaires (Q1b, Q2b) connectés en montage Darlington entre le potentiel haut d'alimentation (Ub) et la borne de sortie (12) de l'amplificateur, la section haute (10b) comportant un transistor additionnel (P3b) ayant un trajet de courant compris entre le potentiel haut d'alimentation (Ub) et la base du transistor de sortie (Q2b) du montage Darlington et commandé par le signal d'entrée (e) de façon que le niveau de potentiel haut du signal de sortie de l'amplificateur soit sensiblement égal au potentiel haut d'alimentation (Ub) diminué de la tension base-émetteur du transistor de sortie (Q2b) du montage Darlington, caractérisé en ce que le montage Darlington de la section haute (10b) est commandé par un premier transistor d'entrée haute (Pb) connecté au potentiel haut (Ub) d'alimentation tandis que la section basse (10a) comporte au moins un autre transistor bipolaire (Q1a) formant avec le transistor de sortie (Q2a) un montage Darlington qui est commandé par un premier transistor d'entrée basse (Na) commandé par le signal d'entrée, les deux premiers transistors (Pb,Na) d'entrée haute et basse étant des transistors à effet de champ complémentaires réagissant au signal d'entrée (e) pour conduire de manière alternée le niveau suivant de ce signal d'entrée (e), en ce que le transistor additionnel de la section haute (10b) est un transistor à effet de champ, et en ce que la section basse (10a) comporte un transistor additionnel à effet de champ (P3a) dont le trajet de courant relie un potentiel fixe à la base du transistor de sortie (Q2a) du montage Darlington de la section basse (10a), le transistor additionnel (P3a) de la section basse (10a) étant commandé par le signal d'entrée (e) durant son niveau de potentiel haut de façon que son type et ledit potentiel fixe (Ub) assurent sa conduction pour fournir au transistor bipolaire de sortie (Q2a) de la section basse (10a) un courant de base de façon à permettre ainsi au niveau de potentiel bas du signal de sortie de l'amplificateur d'être maintenu sensiblement égal au potentiel bas (Ua) d'alimentation.

2. Amplificateur selon la revendication 1, du type constituant un émetteur de bus, un bus (14) étant connecté à la borne de sortie (12) de l'amplificateur, l'amplificateur ayant un troisième état logique commandé par un signal de validation (v) commandant, dans chaque section (10b,10a), un second transistor d'entrée (P'b,Pa) à effet de champ monté en série avec le premier transistor d'entrée respectif (Pb,Na) pour en valider la conduction, l'amplificateur comportant dans chaque section (10b,1a) un transistor à effet de champ de validation (P'3b,P3a) ayant son trajet de courant connecté en série avec celui du transistor additionnel (P3b,P3a) à effet de champ respectif monté dans cette section (10b,10a) et réagissant au signal de validation pour valider la conduction de ce transistor additionnel (P3b,P3a).

3. Amplificateur binaire intégré (10) formant un émetteur de bus (15) préchargé à un potentiel haut d'alimentation (Ub), comprenant une première borne d'entrée (11) recevant un signal d'entrée (e) binaire, une borne de sortie (12) connecté audit bus (15), un transistor bipolaire (Q2) de sortie dont le trajet collecteur-émetteur est compris entre la borne de sortie (12) de l'amplificateur et un potentiel bas d'alimentation (Ua), un transistor d'entrée à effet de champ (N) ayant son trajet de courant relié à la borne de sortie de l'amplificateur et réagissant au signal d'entrée pour commander le transistor bipolaire, une seconde borne d'entrée (13) recevant un signal de validation (v) pour commander un moyen de validation (P, 17) de façon à valider la conduction du transistor bipolaire (Q2), caractérisé en ce que le transistor bipolaire de sortie (Q2) est connecté à au moins un autre transistor bipolaire pour former un montage Darlington commandé par le transistor d'entrée (N), en ce qu'il comporte un transistor additionnel à effet de champ (P3) dont le trajet de courant est en série entre un potentiel fixe (Uc) et la base du transistor bipolaire (Q2) de sortie, le transistor addtionnel (P3) étant commandé par le signal d'entrée (e) durant son niveau de potentiel haut de façon que son type et ledit potentiel fixe (Uc) assurent sa conduction pour fournir au transistor bipolaire de sortie (Q2) un courant de base de façon à permettre ainsi au niveau de potentiel bas du signal de sortie de l'amplificateur d'être maintenu sensiblement égal au potentiel bas (Ua) d'alimentation.

4. Amplificateur selon l'une des revendications 1 à 3, caractérisé en ce que le potentiel fixe (Uc) a la même valeur que le potentiel haut d'alimentation (Ub) de l'amplificateur.

5. Amplificateur selon l'une des revendications 1 à 4, caractérisé en ce qu'il comporte un élément de décharge de la base de chaque transistor bipolaire (Q1, Q2).

6. Amplificateur selon la revendication 5, caractérisé en ce que l'élément de décharge est un transistor à effet de champ (N1, N2) commandé par le signal d'entrée (e) et dont le trajet drain-source relie au potentiel bas d'alimentation (Ua) la base de l'un desdits transistors bipolaires du montage Darlington correspondant.

7. Amplificateur selon la revendication 5, caractérisé en ce que l'élément de décharge est une résistance.

8. Circuit intégré (IC), caractérisé en ce qu'il inclut au moins un amplificateur (10) tel que défini par l'une des revendications 1 à 7.

9. Circuit intégré selon la revendication 8, caractérisé en ce que l'amplificateur (10) est un amplificateur tampon, dont la borne de sortie (12) correspond ou est connectée à une borne de sortie du circuit intégré.

## Patentansprüche

1. Integrierter Binärverstärker (10) mit einem Eingangsanschluß (11), der ein binäres Eingangssignal (e) empfängt, einem Ausgangsanschluß (12), der ein binäres Ausgangssignal (s) liefert, einem niedrigen und einem hohen Versorgungspotential (Ua bzw. Ub), einem unteren Abschnitt (10a) mit einem Ausgangsbipolartransistor (Q2a), dessen Kollektor-Emitter-Pfad zwischen das niedrige Versorgungspotential (Ua) und den Ausgangsanschluß des Verstärkers geschaltet ist, sowie einem oberen Abschnitt (10b), der Bipolartransisotren (Q1b, Q2b) umfaßt, die in einer Darlington-Schaltung zwischen das hohe Versorgungspotential (Ub) und den Ausgangsanschluß (12) des Verstärkers geschaltet sind, wobei der obere Abschnitt (10b) einen zusätzlichen Transistor (P3b) mit einem Strompfad zwischen dem hohen Versorgungspotential (Ub) und der Basis des Ausgangstransistors (Q2b) der Darlington-Schaltung aufweist, der durch das Eingangssignal (e) derart gesteuert wird, daß der Pegel des hohen Potentials des Ausgangssignals des Verstärkers im wesentlichen gleich dem hohen Versorgungspotential (Ub) vermindert um die Basis-Emitter-Spannung des Ausgangstransistors (Q2b) der Darlington-Schaltung ist, dadurch gekennzeichnet, daß die Darlington-Schaltung des oberen Abschnitts (10b) von einem ersten Transistor (Pb) mit hohem Eingang gesteuert wird, der mit dem hohen Versorgungspotential (Ub) verbunden ist, während der untere Abschnitt (10a) wenigstens einen weiteren Bipolartransistor (Q1a) aufweist, der mit dem Ausgangstransistor (Q2a) eine Darlington-Schaltung bildet, die von einem ersten Transistor (Na) mit niedrigem Eingang gesteuert wird, der von dem Eingangssignal gesteuert wird, wobei die beiden ersten Transistoren (Pb, Na) mit hohem bzw. niedrigen Eingang komplementäre Feldeffekttransistoren sind, die auf das Eingangssignal (e) reagieren, um den Pegel dieses Eingangssignals abwechselnd zu führen, daß der zusätzliche Transistor des oberen Abschnitts (10b) ein Feldeffekttransistor ist, und daß der untere Abschnitt (10a) einen zusätzlichen Feldeffekttransistor (P3a) aufweist, dessen Strompfad ein festes Potential mit der Basis des Ausgangstransistors (Q2a) der Darlington-Schaltung des unteren Abschnitts (10a) verbindet, wobei der zusätzliche Transistor (P3a) des unteren Abschnitts (10a) von dem Eingangssignal (e) während seines hohen Potentialpegels derart gesteuert wird, daß sein Typ und das feste Potential (Ub) seinen leitenden Zustand sicherstellen, um dem Ausgangs-Bipolartransistor (Q2a) des unteren Abschnitts (10a) einen Basisstrom zu liefern, so daß es damit möglich wird, daß der niedrige Potentialpegel des Ausgangssignals des Verstärkers im wesentlichen gleich dem niedrigen Versorgungspotential (Ua) gehalten wird.

2. Verstärker nach Anspruch 1 des Typs, der einen Bus-Sender bildet, wobei ein Bus (14) mit dem Ausgangsanschluß (12) des Verstärkers verbunden ist, wobei der Verstärker einen dritten Logikzustand aufweist, der von einem Validierungssignal (v) gesteuert wird, das in jedem Abschnitt (10b, 10a) einen zweiten Feldeffekteingangstransistor (P'b, Pa) steuert, der in Reihe mit dem ersten Eingangstransistor (Pb bzw. Na) geschaltet ist, um seinen leitenden Zustand zu validieren, wobei der Verstärker in jedem Abschnitt (10b, 10a) einen Validierungsfeldeffekttransistor (P'3b bzw. P3a) aufweist, dessen Strompfad in Reihe mit demjenigen des zusätzlichen Feldeffekttransistors (P3b, P3a) geschaltet ist, der jeweils in diesem Abschnitt (10b, 10a) angebracht ist, und der auf das Validierungssignal reagiert, um den leitenden Zustand dieses zusätzlichen Transistors (P3b, P3a) zu validieren.

3. Integrierter Binärverstärker (10), der einen auf ein hohes Versorgungspotential (Ub) vorgeladenen Bus-Sender (15) bildet, mit einem ersten Eingangsanschluß (11), der ein binäres Eingangssignal (e) empfängt, einem mit dem Bus (15) verbundenen Ausgangsanschluß (12), einem Ausgangsbipolartransistor (Q2), dessen Kollektor-Emitter-Pfad zwischen dem Ausgangsanschluß und einem niedrigen Versorgungspotential (Ua) liegt, einem Eingangs-Feldeffekttransistor (N), dessen Strompfad mit dem Ausgangsanschluß des Verstärkers verbunden ist und der auf das Eingangssignal reagiert, um den Bipolartransistor zu steuern, einem zweiten Eingangsanschluß (13), der ein Validierungssignal (v) emfängt, um ein Validierungsmittel (P, 17) derart zu steuern, daß der leitende Zustand des Bipolartransistors (Q2) validiert wird, dadurch gekennzeichnet, daß der Ausgangs-Bipolartransistor (Q2) mit wenigstens einem weiteren Bipolartransistor verbunden ist, um eine Darlington-Schaltung zu bilden, die von dem Eingangstransistor (N) gesteuert wird, daß er einen zusätzlichen Feldeffekttransistor (P3) aufweist, dessen Strompfad in Reihe zwischen einem festen Potential (Uc) und der Basis des Ausgangs-Bipolartransistors (Q2) liegt, wobei der zusätzliche Transistor (P3) von dem Eingangssignal (e) während seines hohen Potentialpegels derart gesteuert wird, daß sein Typ und das feste Potential (Uc) seinen leitenden Zustand sicherstellen, um dem Ausgangs-Bipolartransistor (Q2) einen Basisstrom zu liefern, so daß es damit möglich wird, daß der niedrige Potentialpegel des Ausgangssignals des Verstärkers im wesentlichen gleich dem niedrigen Versorgungspotential (Ua) gehalten wird.

4. Verstärker nach einem der Ansprüche 1 bis 3, dadurch gekennzeichnet, daß das feste Potential (Uc) den gleichen Wert wie das hohe Versorgungspotential (Ub) des Verstärkers aufweist.

5. Verstärker nach einem der Ansprüche 1 bis 4, dadurch gekennzeichnet, daß er ein Element zum Entladen der Basis jedes Bipolartransistors (Q1, Q2) aufweist.

6. Verstärker nach Anspruch 5, dadurch gekennzeichnet, daß das Entladungselement ein Feldeffekttransistor (N1, N2) ist, der von dem Eingangssignal (e) gesteuert wird und dessen Drain-Source-Pfad die Basis eines der Bipolartransistoren der entsprechenden Darlington-Schaltung mit dem niedrigen Versorgungspotential (Ua) verbindet.

7. Verstärker nach Anspruch 5, dadurch gekennzeichnet, daß das Entladungselement ein Widerstand ist.

8. Integrierte Schaltung (IC), dadurch gekennzeichnet, daß sie wenigstens einen Verstärker (10) nach der Definition eines der Ansprüche 1 bis 7 umfaßt.

9. Integrierte Schaltung nach Anspruch 8, dadurch gekennzeichnet, daß der Verstärker (10) ein Pufferverstärker ist, dessen Ausgangsanschluß (12) einem Ausgangsanschluß der integrierten Schaltung entspricht oder damit verbunden ist.

## Claims

1. Integrated binary amplifier (10) comprising an input terminal (11) receiving a binary input signal (e), an output terminal (12) supplying a binary output signal (s), a low supply potential (Ua) and high supply potential (Ub), a low section (10a) comprising an output bipolar transistor (Q2a), the collector-emitter path of which is connected between the low supply potential (Ua) and the output terminal of the amplifier, and a high section (10b) including bipolar transistors (Q1b, Q2b) connected in Darlington configuration between the high supply potential (Ub) and the output terminal (12) of the amplifier, the high section (10b) comprising an additional transistor (P3b) having a current path comprised between the high supply potential (Ub) and the base of the output transistor (Q2b) of the Darlington configuration and controlled by the input signal (e) so that the high potential level of the output signal of the amplifier is substantially equal to the high supply potential (Ub) reduced by the base-emitter voltage of the output transistor (Q2b) of the Darlington configuration, characterised in that the Darlington configuration of the high section (10b) is controlled by a first high-input transistor (Pb) connected to the high supply potential (Ub) while the low section (10a) comprises at least one other bipolar transistor (Q1a) forming, together with the output transistor (Q2a), a Darlington configuration that is controlled by a first low-input transistor (Na) controlled by the input signal, the first two high- and low-input transistors (Pb, Na) being complementary field-effect transistors reacting to the input signal (e) in order to conduct alternately, depending on the level of this input signal (e), in that the additional transistor of the high section (10b) is a field-effect transistor, and in that the low section (10a) comprises an additional field-effect transistor (P3a), the current path of which connects a fixed potential to the base of the output transistor (Q2a) of the Darlington configuration of the low section (10a), the additional transistor (P3a) of the low section (10a) being controlled by the input signal (e) during its high potential level so that its type and said fixed potential (Ub) ensure that it is conducting so as to supply the output bipolar transistor (Q2a) of the low section (10a) with a base current so as to allow the low potential level of the output signal of the amplifier thus to be kept substantially equal to the low supply potential (Ua).

2. Amplifier according to Claim 1, of the type constituting a bus transmitter, a bus (14) being connected to the output terminal (12) of the amplifier, the amplifier having a third logic state controlled by a validation signal (v) controlling, in each section (10b, 10a), a second input field-effect transistor (P'b, Pa) in series with the respective first input transistor (Pb, Na) in order to validate its conduction, the amplifier comprising, in each section (10b, 1a), a validation field-effect transistor (P'3b, P3a) having its current path connected in series with that of the respective additional field-effect transistor (P3b, P3a) mounted in this section (10b, 10a) and reacting to the validation signal in order to validate the conduction of this additional transistor (P3b, P3a).

3. Integrated binary amplifier (10) forming a preloaded bus transmitter (15) with a high supply potential (Ub) comprising a first input terminal (11) receiving a binary input signal (e), an output terminal (12) connected to said bus (15), an output bipolar transistor (Q2), the collector-emitter path of which is comprised between the output terminal (12) of the amplifier and a low supply potential (Ua), a field-effect input transistor (N) having its current path connected to the output terminal of the amplifier and reacting to the input signal in order to control the bipolar transistor, a second input terminal (13) receiving a validation signal (v) in order to control a validation means (P, 17) so as to validate the conduction of the bipolar transistor (Q2), characterised in that the bipolar output transistor (Q2) is connected to at least one other bipolar transistor so as to form a Darlington configuration controlled by the input transistor (N), in that it comprises an additional field-effect transistor (P3), the current path of which is in series between a fixed potential (Uc) and the base of the output bipolar transistor (Q2), the additional transistor (P3) being controlled by the input signal (e) during its high potential level so that its type and said fixed potential (Uc) ensure that it is conducting in order to supply to the output bipolar transistor (Q2) a base current so as to allow the low potential level of the output signal of the amplifier thus to be kept substantially equal to the low supply potential (Ua).

4. Amplifier according to one of the Claims 1 to 3, characterised in that the fixed potential (Uc) has the same value as the high supply potential (Ub) of the amplifier.

5. Amplifier according to one of Claims 1 to 4, characterised in that it comprises an element for discharging the base of each bipolar transistor (Q1, Q2).

6. Amplifier according to Claim 5, characterised in that the discharge element is a field-effect transistor (N1, N2) controlled by the input signal (e) and the drain-source path of which connects to the low supply potential (Ua) the base of one of said bipolar transistors of the corresponding Darlington configuration.

7. Amplifier according to Claim 5, characterised in that the discharge element is a resistor.

8. Integrated circuit (IC), characterised in that it includes at least one amplifier (10) as defined by one of Claims 1 to 7.

9. Integrated circuit according to Claim 8, characterised in that the amplifier (10) is a buffer amplifier, the output terminal (12) of which corresponds or is connected to an output terminal of the integrated circuit.
